# EUROPEAN PATENT APPLICATION

(11) **EP 3 611 769 A1**
(43) Date of publication of application: **19.02.2020**
(21) Application number: 19190903.5
(22) Date of filing: 08.08.2019
(51) Int. Cl.: H01L 35/30

(54) **SYSTEM FOR HEAT RECOVERY**

(30) Priority: 08.08.2018 PT 2018111106
(71) Applicant: Universidade do Minho, 4704-553 Braga (PT)
(72) Inventor: CARRUSCA PIMENTA DE BRITO, FRANCISCO, 4800-058 GUIMARÃES (PT); GOMES MARTINS, JORGE JOSÉ, 4800-058 GUIMARÃES (PT); VALENTE GONÇALVES, LUÍS MIGUEL, 4800-058 GUIMARÃES (PT); SOUSA VIEIRA, RUI DANIEL, 4800-058 GUIMARÃES (PT); FREITAS PACHECO, NUNO MIGUEL, 4800-058 GUIMARÃES (PT); FERNANDES TEIXEIRA, JOSÉ CARLOS, 4800-058 GUIMARÃES (PT)
(74) Representative: Patentree

(57) **Abstract**

The disclosure includes a system and method thereof that implements the recovery of heat from a variable thermal load application and the delivery and spreading of this heat at a controllable temperature range to the target application such as a thermoelectric generator. The disclosure comprises a heat spreader (3) located between a hot source heat exchanger (4) and a target application (2) which uses liquid-vapour phase change to lower temperature and spread heat along the target application (2) avoiding the risk of overheating under high loads and thermal dilution under low loads. This effect is obtained by embedding variable conductance heat pipes, thermosiphons or vapour chambers in the spreader (3), within the heat path which absorb the heat by vaporization whenever this heat is above the phase change temperature. This phase change temperature is regulated via the inclusion of a non-condensable gas inside the chambers of the heat spreader. The disclosure can be fitted into an automobile exhaust pipe or adapted for industrial processes that produce a usable heat flow to be used as inlet flow (7) to the system. The disclosure is especially suitable for applications involving thermoelectric modules for electrical production in automobiles or in stationary applications with variable thermal load and in general applications which require temperature stability.

## Description

### TECHNICAL FIELD

The present disclosure relates to a system that comprises a heat exchanger for the recovery and/or retrieval of heat from fluid inlet flows in situations where the thermal level, at which this heat is supplied, is adequate for a target application. Particularly, it is a heat exchanger intended for thermoelectric generation and other target applications which may benefit from the stabilization of an otherwise thermally unsteady input.

### BACKGROUND

There are many processes that waste some of the thermal energy involved in the process, that is, some heat involved in the process leaves the application without being used in a useful manner. This is the case of thermal engines, which typically waste more heat than they convert into useful work. It is also the case for many industrial processes which involve thermal energy such as those of cement, ceramic or textile industries, among others. Hot surfaces in general lose heat to their surroundings. Some of this unused/wasted heat can be recovered in various ways, improving the overall energy efficiency of the processes.

A notable example of this energy recovery is the direct conversion of heat into electricity done by thermoelectric generators (TEGs) operating under the Seebeck effect. In some of these heat recovery applications (in which TEGs are included), it is important to have control over the thermal level at which the heat is transferred to the target application (2). For instance, there are target applications in which there is a maximum temperature over which a component will be damaged or other undesirable effects will happen. Often, it is also desirable that the thermal level of the target application (2) will not drop below certain levels. For instance, TEG output is highly sensitive to the thermal level, it is desirable that they operate as close as possible to their thermal limit.

Therefore, being able to control the temperature at which the heat is transferred by a heat exchanger is an advantage for several applications. A system which may lower the temperature of a highly variable thermal source (such as an engine exhaust) to a narrowly optimized temperature range will be advantageous. The heat exchanger proposed by the current disclosure aims to achieve this.

Several solutions were already presented in the state of the art. Many scientific journal papers describe use of constant conductance heat pipes (CCHPs), some in thermoelectric applications. However, the solutions described cannot achieve thermal control since CCHPs do not allow this (Orr, 2014, Remeli, 2015, 2016, Liu, 2016, Kim, 2011).

Jaworski, 2016 describes use of solid to liquid phase change materials (PCMs). PCMs allow some thermal control but their latent heat is one order of magnitude lower than liquid to vapour systems and do not provide the heat source or heat sink module, neither does it provide a variable active heat transfer area.

Some papers describe the use of variable conductance heat pipes (VCHPs) for different purposes.

Document Thermoelectric Module-Variable Conductance Heat Pipe Assemblies for Reduced Power Temperature Control (Melnick, 2012) describes variable conductance heat pipe used instead of conventional heat sinks to reduce the power consumption of thermoelectric cooler by passively altering the thermal resistance of the thermoelectric cooler in response to changes in operating conditions. This concept differs from the present disclosure because it is used in a cooling device for energy saving purposes and not for temperature control.

Documents DE102012202150, WO2012038917, CN106329998 and US2014007915 use solid to liquid phase change (PCMs) instead of a liquid to vapour phase change. Moreover, the systems disclosed in these documents do not prevent thermal dilution, only protection against overheating or thermal storage.

Document US2010186398 refers to a TEG containing a compartment filled with an evaporable working medium between the heat source and the thermoelectric modules. The inventor uses the latent heat of phase change for protection of a TEG against overheating. Therefore, it protects against overheating but not against thermal dilution (unlike the present disclosure, it has a constant active module). Moreover, the heat is transmitted through the working fluid even when this working fluid is not boiling, thus rending the TEG with a high thermal resistance. The TEG described does not transmit heat by conduction through metal parts and/or by phase change.

Document CN105429510 refers to a solution that combines heat pipes and TEGs. The heat pipes are not used for thermal control but for allowing the radiator of the system to be located away from the thermoelectric generator.

There are already some systems in the prior art that tried to address the problem of temperature limitation. Some systems use a bypass valve to divert the exhaust gases when there is a risk of overheating while others use a constant conductance heat pipe / thermosiphon to transfer the heat. However, the systems described in the prior art fail to achieve control over the temperature.

These facts are disclosed in order to illustrate the technical problem addressed by the present disclosure.

### GENERAL DESCRIPTION

The present disclosure relates to a system that comprises a heat exchanger for the recovery/retrieval of heat from fluid inlet flows in situations where the thermal level at which this heat is supplied to the target application is an intended feature. Particularly, it is a heat exchanger intended for thermoelectric generation and other target applications which may benefit from the stabilization of an otherwise thermally unsteady input.

The present disclosure is especially useful for the utilization of the heat from highly variable thermal load (variable inlet flow rate and/or variable temperature) fluid flows such as those encountered in thermal engine exhaust or in various industrial applications.

An aspect of the present disclosure relates to use of variable conductance heat pipes, thermosiphons or vapour chambers to control both the temperature and the active heat transfer area. It does this in a passive way without the need for electronic control. It is therefore advantageous for waste heat recovery under highly variable thermal load.

Another aspect of the present disclosure relates to the use of phase-change phenomena to achieve thermal stability of the heat source for the target application by using variable conductance heat pipes, thermosiphons or vapour chambers/flat heat pipes.

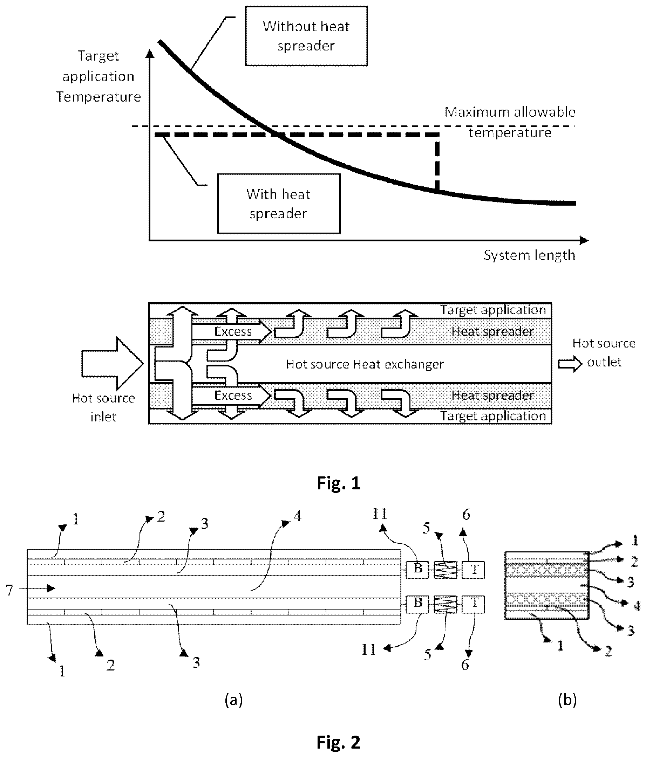

The system of the disclosure is able to extract heat from all applications which release usable heat through fluid flows and transfer it to a target application at a controlled temperature range and for an active heat transfer area which will be proportional to the thermal load (as exemplarily depicted in Fig. 1). The present disclosure is especially useful for waste heat recovery using thermoelectric devices but it is not limited to it. Any target application that might benefit from the conversion of a variable thermal power source to a controlled temperature range thermal source is a possible target application for the heat exchanger. With regard to TEGs, possible applications are the conversion of thermal engine exhaust waste heat, and other waste heat sources in industrial or domestic applications such as boilers, process heat, solar heat and any other target application having a thermal energy source. This concept is also useful for the opposite effect of heat recovery which is passively controlled cooling.

This present disclosure aims to recover heat contained in an inlet flow and transfer this heat to a target application, notably thermoelectric generators, at a controlled temperature range through a heat spreader based on variable conduction heat pipes, thermosiphons or vapour chambers. These latter components are the basis for the heat spreading feature which is responsible for spreading the variable incoming thermal power contained in an inlet flow along a proportional active heat transfer area and enabling this area of the target application to remain within a controlled range of temperature.

In an embodiment, the controlled heat spreading feature downgrades thermal fluxes through liquid/vapour phase change under controlled pressure.

In an embodiment, the various components disclosed affect the way through in which the heat transfer, heat spreading and temperature control is implemented.

In an embodiment, according to the geometry used, the heat transfer may be performed through the vapour only or also through conduction. This will mean that the vapour may be responsible for transporting all the heat to the target application or only responsible for spreading the excess heat. Also, the return of the condensates to the vaporizing region may be performed through gravity or through capillary pumping. The former has more potential for thermal power transfer but the latter allows for applications where the use of gravity is not a viable option. The various geometries of the inner chambers of the heat spreader will have different potential for the capillary flow and for the vapour-gas stratification.

In an embodiment, the heat spreading feature not only enables protection from overheating without the need for wasting high thermal load events (as in the case of by-pass systems) but it will also reduce thermal dilution under low thermal loads since it will be possible to use highly effective hot source heat exchangers without the fear of overheating.

Another aspect of the present disclosure relates to the use of the device in target applications where overheating and thermal dilution are to be avoided, namely in highly variable thermal sources. An example will be thermoelectric generation in the recovery of waste heat involved in engine operation and industrial processes.

The materials of the disclosure are important insofar as they affect the thermal, mechanical and corrosion resistance of the application.

In an embodiment, the materials of the hot source heat exchanger is be able to effectively absorb the heat from the heat source and deliver it to the target application while maintaining their integrity and providing resistance to the possibly high pressures generated by the vapour. The materials of the heat spreader is able to endure the pressures involved and be highly conductive in the case where conductive heat transfer is desired.

In an embodiment, the phase change fluid to be used is any phase change fluid which allows it to work within the intended temperature and pressure ranges and is compatible with the materials of the system.

In an embodiment, the non-condensable gas is any gas that is able to ensure that self-ignition conditions of the mixture are never met. It should also be a gas which favours vapour-gas stratification.

Another aspect of the present disclosure relates to passive thermal control, as the disclosed system allows regulations of the thermal level of the heat to achieve the desired level. The disclosed system may be integrated into various applications such as vehicles or other equipment/processes which include at least one inlet flow with usable heat or an inlet flow from which heat must be retrieved.

The present application is advantageous for the conversion of heat into electricity using thermoelectric generators. While this is an especially useful application of the disclosure, it is not limited to this use and the thermoelectric devices are not mandatory. They are commercially available. This disclosure includes a concept which may be applied in different ways to several different products incorporating energy recovery such as vehicles, industrial processes, etc.

It is disclosed a system for efficient heat recovery comprising a hot source heat exchanger to where the inlet flow flows, a target application, heat sinks and a heat spreader that is between the hot source heat exchanger and the target application.

In an embodiment, the heat spreader may be one straight plane or folded into several planes which are stacked into each other and linked in series in zig-zag or linked in parallel.

In an embodiment, the heat spreader has chambers selected from heat pipes or thermosiphons or vapour chambers, or holes, among others.

In an embodiment, each chamber is isolated from the others through a wall or they are interconnected or are united in a manner to provide one sole chamber.

In an embodiment, the chambers have wicks, meshes, metallic foams, channels or other features to promote capillary flow of the phase change fluid, when in liquid phase, inside the chambers of the heat spreader.

In an embodiment, the chambers of the heat spreader comprise a phase changing fluid and a non-condensable gas in their interior.

In an embodiment, the phase change fluid allows to work within the intended temperature and pressure ranges and is compatible with the materials of the system.

In an embodiment, the phase change fluid is selected from Water or Dowtherm-A, as high and low pressure phase change fluids for target application temperatures around 250°C.

In an embodiment, the non-condensable gas is compatible with the materials of the system, it favours the stratification between vapour and non-condensable gas and it ensures that a non-flammable mixture exists or at least self-ignition conditions of the mixture are never met, selected from Nitrogen, Air, Carbon Dioxide, Argon, Helium, among others, depending on the phase change fluid and the materials of the chamber walls.

In an embodiment, the heat spreader will extend for the whole length of the system.

In an embodiment, the hot source heat exchanger is a compact heat exchanger, comprising extended surfaces at the fluid side such as straight fin or wavy fin or offset fin or corrugated pipes or a tube bank, among others.

In an embodiment, it optionally comprises one or more expansion tank volumes located after an optional excess vapour condenser, or after an optional buffer volume or at the downstream end of the heat spreader.

In an embodiment, the target application is a thermoelectric generator.

In an embodiment, optionally the hot source heat exchanger and heat spreader are substituted by a standalone hot source heat exchanger and a standalone heat spreader, respectively.

In an embodiment, the standalone hot source heat exchanger is an evaporator which is separated both from the standalone heat spreader and the target application, and the standalone heat spreader is a condenser which is attached to the target application.

In an embodiment, the standalone hot source heat exchanger and the standalone heat spreader are connected in loop by a vapour line and a liquid line or in series, by one single line.

In an embodiment, the heat contained in a variable thermal load inlet flow is absorbed by the hot source heat exchanger or standalone hot source heat exchanger and is transmitted to the target application via the heat spreader or standalone heat spreader.

It is also disclosed a method for operating the disclosed system, wherein the phase change fluid contained within the chambers of the heat spreader will downgrade the temperature of the heat coming from the inlet flow down to an intended temperature range and deliver this heat to the target application through:
i) absorption of this heat through vaporization of the phase change fluid;
ii) spreading of this heat via the spreading of the generated vapour along the heat spreader or standalone heat spreader chambers' length;
iii) condensation of this vapour along an area of the chambers occupied by the vapour
iv) absorption of this heat by the target application in the area occupied by the vapour.

In an embodiment, the heat may be transmitted totally or partially to the target application through conduction across the heat spreader material or by phase change.

In an embodiment, the conductive heat transfer will exist whenever there is a heat path for conduction across the solid regions of the heat spreader not occupied by chambers and will be negligible if the thermal resistance of this heat path is too big, as in the case where the chambers occupy all or most of the section area of the heat spreader or standalone heat spreader.

In an embodiment, the heat transferred by phase change will only occur when boiling conditions are met within the chambers.

In an embodiment, the heat which crosses the heat spreader coming from the hot source heat exchanger to the target application will cross it exclusively by conduction (or no heat transfer will occur if conduction is not present) across the heat spreader body, as long as the temperature of the phase change fluid inside the chambers does not achieve the boiling temperature and once this temperature is achieved, the spreading feature will start occurring along the length of the heat spreader, with vapour being generated in the hotter regions of the heat spreader where boiling conditions are present and with the vapour spreading along the length of the heat spreader, condensing and releasing its latent heat in the cooler regions of the heat spreader where condensation conditions are present, and transmitting this heat to the target application.

In an embodiment, the heat transfer temperature range during operation may be regulated by adjusting the pre-charge pressure of the non-condensable gas, by adjusting the chamber volume, by adjusting the optional buffer and optional expansion tank volumes and by adjusting the total phase change fluid mass.

In an embodiment, a significant stratification between vapour and non-condensable gas is achieved, enabling the system to operate with an active area which is proportional to the incoming thermal load achieved by
i) using chamber geometries which prevent natural convection and mixing between vapour and non-condensable gas, namely multiple small section channels;
ii) using a geometry of the system and a combination of phase change fluid and non-condensable with densities which favour the accumulation of the vapour and non-condensable gas in the active and non-active areas of the system, respectively.

In an embodiment, it is possible to accumulate surplus vapour in high thermal power events and then use it in lower power events, by using at least one buffer volume at the downstream end of the heat spreader or standalone heat spreader.

In an embodiment, it is possible to limit the maximum amount of vapour present in the system and therefore limit the maximum pressure and temperature of the system under high load events, by using at least one optional excess vapour condenser at the downstream end of the heat spreader or standalone heat spreader after the optional buffer volume so that the surplus vapour reaching the excess vapour condenser will condense and therefore avoid excess pressure and temperature.

In an embodiment, it is possible to increase pressure and temperature stability of the system by incorporating at least one optional expansion volume at the downstream end of the heat spreader or standalone heat spreader after the optional excess vapour condenser if present and higher volumes should be used, if a lower variation of the pressure between standby and maximum thermal load is intended.

In an embodiment, the return of the condensates to the vaporization region and the wetting of these surfaces is made by
i) capillary pumping through wicks, meshes, metallic foams, arteries, grooves, channels and other structures as used in heat pipes and vapour chambers from the literature or
ii) gravity assistance, by locating the condensation regions at a higher location than the vaporization region and providing sufficient inclination to the regions where the condensates flow back to the vaporization regions; or
iii) a combination of i) and ii); or
iv) loop effect similar to what happens in loop heat pipes / thermosiphons.

### BRIEF DESCRIPTION OF THE DRAWINGS

The following figures provide preferred embodiments for illustrating the disclosure and should not be seen as limiting the scope of invention.
**Figure 1** represents an outline of the heat spreading effect provided by the disclosed system.
**Figure 2** represents a schematic lateral and frontal/section view of the disclosed system for use with a thermoelectric generator application.
**Figure** 3 represents schematic examples of the frontal/sectional view of alternative configurations of the disclosed system using stacked hot source parallel flow and prismatic hot source parallel flow along several faces.
**Figure 4** represents a schematic lateral and frontal/sectional view of the disclosed system with an extension (in series) of the heat spreader beyond the hot source heat exchanger into secondary levels stacked above the base level.
**Figure 5** represents a schematic lateral view of the disclosed system for a thermoelectric generator application.
**Figure 6** represents a schematic lateral and frontal/sectional view of the disclosed system for a thermoelectric generator application.
**Figure 7** represents a schematic lateral and frontal/sectional view of the disclosed system for a thermoelectric generator application.

The following references to the drawings are used:
1 - Heat Sinks; 2 - Target application (e.g. thermoelectric modules); 3 - Heat spreader; 4 - Hot source heat exchanger; 5 - Excess vapour condenser; 6 - Expansion tank volume; 7 - Inlet flow; 8 - Standalone hot source heat exchanger (evaporator); 9 - Vapour line; 10 - Liquid (condensates) line; 11 - Buffer volume; 12 - Standalone heat spreader (condenser); 13 - Extension of the heat spreader and target application (in series)

### DETAILED DESCRIPTION

The present disclosure relates to a system that comprises a heat exchanger for the recovery/retrieval of heat from fluid inlet flows in situations where the thermal level at which this heat is intended to be supplied to the target application. Particularly, it is a heat exchanger intended for thermoelectric generation and other target applications which may benefit from the stabilization of an otherwise thermally unsteady input.

An aspect of the present disclosure relates to the absorption of some of the heat contained in an inlet flow (7) from a variable thermal power source using a hot source heat exchanger (4) and transfer this heat to a target application (2) that can be selected between thermoelectric modules or any other application that may require temperature limitation or benefit from thermal stability.

In an embodiment, the thermal level at the target application is adapted so that both overheating and thermal dilution are averted. To do this, an interface acting as heat spreader (3) is applied between the hot source heat exchanger (4) through which the hot fluid inlet flow (7) is passing through, and the target application (2). This spreader (3) incorporates phase change phenomena which enables lowering of the temperature of the incoming heat flux down to a level which is optimal for the target application (2) irrespective of the heat source variability. This is done in a simple passive way. The temperature stability provided by the heat spreader (3) is based upon the use of phase change phenomena within it. More specifically, a portion of the heat will be absorbed from the hot source heat exchanger (4) by boiling in the hotter chamber regions where boiling conditions are met, the generated vapour will spread along the heat spreader (3) and it will finally condense in the cooler regions of the vapour region where condensation conditions are met, releasing this heat to the target application. This phase change will occur at a specific temperature due to the fact that the boiling temperature of a fluid depends mainly on the local pressure. The pressure of the heat spreader chambers (3) will be pre-regulated by regulating the pre-charge pressure of a non-condensable gas which is injected into these chambers prior to operation through a pressure connector. Under operation this pressure will vary between specific bounds according to the thermal input. These bounds can be adjusted according to the geometry (e.g. volume) of the chambers and other volumes attached to the system (e.g. optional buffer volume (11) and optional expansion volume (6)) and the mass of the phase change fluid present inside the system.

In an embodiment, the heat spreader (3) transfers the heat from the hot source heat exchanger (4) to the target application (2), converting the temperature of this heat to the desired level at the target application (2). The lower or higher incoming thermal load will mainly affect the level of heat spreading and not the heat transfer temperature, with the spreading being proportional to the incoming heat. By selecting the volume of the system, the type and amount of phase-change fluid and the type, amount and pre-charge pressure of non-condensable gas, it is possible to establish bounds to the variation of the operating pressure and temperature of the system.

In an embodiment, the phase change fluid is selected according to the intended pressure range and thermodynamic properties. Water is a very good choice in terms of high latent heat but requires around 40 bar of pressure operation to achieve a 250 °C operating temperature. On the other hand, Dowtherm-A will operate at this temperature at 1 bar but will have a much lower latent heat, rising the flow rate per unit of power transfer. Dowtherm-A is a heat transfer fluid which is a eutectic mixture of two stable organic compounds, biphenyl (C₁₂H₁₀) and diphenyl oxide (C₁₂H₁₀O). These compounds have practically the same vapor pressures, so the mixture can be handled as if it were a single compound. Dowtherm-A fluid may be used in systems employing either liquid phase or vapor phase heating. Its normal application range is 60 °F to 750 °F (15 °C to 400 °C), and its pressure range is from atmospheric to 152.5 psig (10.6 bar).

In an embodiment, the non-condensable gas is a gas which will not react with the phase change fluid and allow for a good stratification. Air may be used but inert gases such as nitrogen, argon, carbon dioxide or helium are preferable. The density of the non-condensable gas, in particular said inert gases, relative to vapour should be such that it favours stratification along the device; and accumulation of the vapour and non-condensable gas in the active and non-active areas of the system, respectively.

In an embodiment, a significant stratification between the existing vapour and the non-condensable gas is achieved by: i) using chamber geometries which promote this stratification, namely, by using multiple small section area chambers which avoid natural convection and mixing between vapour and non-condensable gas; ii) using a combination of phase change fluid and non-condensable gas which favours the denser and lighter fluids to remain at the lower and higher regions of the system, respectively. This stratification enables the system to operate with an active area which is proportional to the incoming thermal load. This active area will correspond to the area where vapour is present and it will be the area where the bulk of the heat transfer to the target application will occur.

The system of the present disclosure relies on the same principles of gas-filled variable conductance heat pipes, thermosiphons or vapour chambers. However, it is used specifically to achieve thermal control.

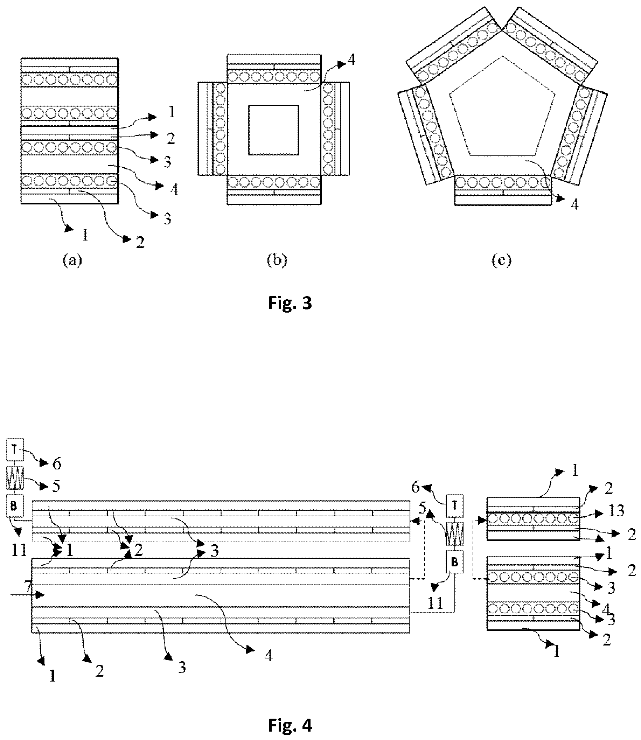

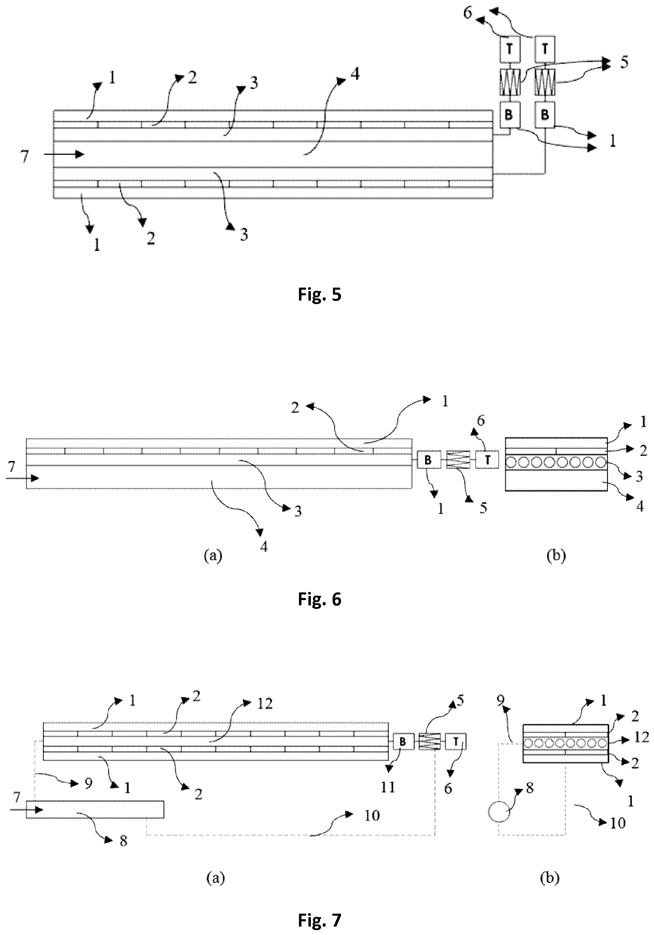

The first named embodiment of the disclosure is the one represented schematically by Fig. 2, the target application (2) is a thermoelectric generator with thermoelectric modules heated at the hot side, by the hot source heat exchanger (4) and heat spreader (3) and cooled at the cold side by heat sinks (1). Fig. 2 shows a system with up-down symmetry. Fig. 3. Shows a system with only one single heat flow path or multiple flow paths arranged in parallel with each one supplying a target application (2). For instance, in the case of thermoelectric modules, the thermal inlet flow (7) could be distributed along several stacked groups of modules (Fig. 3a) or along several parallel sections aligned side by side in a triangular, rectangular, pentagonal, hexagonal shape, etc. as depicted in Fig. 3b, c. The base heat spreader (3) and the target applications (2) may also extend beyond the length of the hot source heat exchanger and have this extra length (13) folded and stacked in several layers above or below the base body containing the hot source heat exchanger (4). Fig. 7 is an example of this, with an extension of the heat spreader (13) and the addition of a new level of thermoelectric modules along this extension. In the example of Fig. 4, this secondary body is stacked on top the base level. Note that the hot source heat exchanger (4) is only in contact with the base level of the heat spreader (3), not with its extension (13). Therefore, the heat reaches the secondary levels (13) only through the vapour.

In an embodiment, the geometry of the system is chosen according to the size of the system, availability of space and intended compactness of the system.

In an embodiment, there is an inlet flow (7) entering into the system. This inlet flow (7) may be any gaseous or liquid flow with an inlet temperature which is sufficiently high so as to make it energetically valuable for the target application (2). It will typically be waste heat from thermal engines (e.g. exhaust or radiator thermal energy) or industrial processes. It may also be thermal energy specifically produced from renewable or non-renewable sources and intended to be converted into more useful types of energy (e.g. electricity).

In an embodiment, the hot source heat exchanger (4) absorbs a percentage of the heat contained in the inlet flow (7). The percentage of the maximum absorbable heat is called the effectiveness of the heat exchanger. Conventional applications cannot have a very high effectiveness without the danger of overheating in high thermal load events. Using the heat spreading feature eliminates this limitation, so the effectiveness of the hot source heat exchanger (4) can be as high as desired, as long as it is economically viable and with an acceptable volume and weight. An average effectiveness above 85% seems feasible with this system.

In an embodiment, the geometry of this hot source heat exchanger (4) may be any geometry suitable for the purpose, optimized for heat transfer effectiveness, volume, weight, cost and pressure. Typically, it is a compact heat exchanger with extended surfaces (e.g. fins) at the fluid side, such as straight fin, wavy fin, offset fin or corrugated pipes heat exchanger, or a tube bank heat exchanger. All these geometries should preferably be capable of withstanding the temperature, corrosive environment and pressure of the application with low generated back pressure. A possible way of having a system which is simultaneously corrosion resistance to high temperature fluids at the inlet flow (such as exhaust gases) and still have a low overall conductive resistance is to embed both the channels of the hot source heat exchanger (4) and the channels for the heat spreader (3) in a cast aluminium body. The former ones would be made of corrosion resistance materials such as stainless steel, while the latter ones would be commercial / custom heat pipes / vapour chambers made of copper, stainless steel or other materials. The cast aluminium in which they would be embedded would ensure a low conductive heat transfer resistance for the system with a viable bonding between dissimilar materials.

In an embodiment, the heat retrieved by the hot source heat exchanger (4) is then transferred to the heat spreader (3) by conduction. The heat spreader (3) consists of a thermally conductive interface (typically, a metallic body) located at the heat path between the hot source heat exchanger (4) and the target application (2). This heat spreader (3) has embedded gas-loaded / variable conductance heat pipes, thermosiphons, vapour chambers, flat heat pipes, or similar. Substantially, this is a block/plate/body containing inner chambers within it. These chambers extend along the length of the heat spreader (3). These chambers can have various geometries according to the desired effect, from round to straight walls, with thicker or thinner walls, with a lower or higher amount of chambers, they may be isolated from each other, interconnected or even constitute a sole chamber. The chamber geometry will be important insofar as it enables vapour/non-condensable gas stratification, it enables more or less the conductive heat transfer across it as desired and it withstands the operating pressure. These chambers contain a phase changing fluid and a non-condensable gas in their interior. These chambers may be an integral part of the heat spreader (3) body or they may consist of pipes embedded/sandwiched within or attached to a conductive body or plate. These chambers are pre-charged at a given pre-charge pressure with the non-condensable gas. This pre-charge pressure ensures that the fluid within them will start boiling (and thus spreading heat) at a well-defined temperature, which will be close to the optimal operating temperature of the target application (2) (such as thermoelectric modules). For example, in the case of thermoelectric modules with an ideal operating temperature of 250 °C, the pre-charge pressure should be such that the maximum operating pressure will achieve around 40 bar for the case of water and 1 bar for the case of Dowtherm-A as phase change fluid. The bigger the system volume, the lower will be the difference between the pre-charge pressure and the maximum operating pressure at full load. The estimation of the maximum operating pressure may be done with thermodynamic analysis.

In an embodiment, the inner surface of these chambers has capillarity pumping inducing structures such as wicks, meshes, metallic foams, arteries, grooves, channels and other suitable features to promote capillary flow as found in established heat pipe and vapour chamber literature. This allows operation without the need for gravity support, although gravity support will help if available. The geometry of these chambers should be suitable both for the capillary pumping effect and for withstanding the inner pressure present inside the system. The geometry should also be optimized to minimize thermal resistance to the conductive heat transfer across the spreader which is a feature of this embodiment.

In an embodiment, when the heat is absorbed by the hot source heat exchanger (4) it will cross the heat spreader (3) through conduction and reach the target application (2), that can be a thermoelectric generator or another application benefiting from thermal control. If the temperature of the spreader (3) does not exceed the boiling temperature of the working fluid, nothing will happen inside the chambers, with all the heat being transferred to the target application (2) by conduction across the solid bodies of the heat spreader (3). However, if the temperature of the spreader (3) exceeds the boiling temperature, the working fluid will start absorbing this excess energy and boil. As the fluid boils, it absorbs the excess heat spreading it in the downstream direction: a vapour volume is created at the hottest regions, the most upstream location within the chambers, displacing the non-condensable gas downstream, towards the direction of the expansion tank volume (6). This way, a vapour zone and a non-condensable gas zone of the chambers are created. The more vapour is produced, the higher the fraction of the chamber volume is occupied by vapour.

In an embodiment, the heat spreader (3) has the function of spreading the surplus heat at a given upstream location displacing it to a heat deficit region located further downstream, where the vapour will condensate and release this heat. This spreading feature is obtained through the travelling of the vapour from the hotter regions located upstream where it was generated, to the colder regions located downstream where the vapour will condensate and release its latent heat. The returning of the condensates from the condensation region back to the vaporization region is done by capillary effect or by gravity, if available, or by both.

Therefore, as long as the target temperature of the application is not achieved, the system works as a conventional heat exchanger, with the heat spreading (3) function not being active. However, once the target temperature of the application is achieved, the excess heat will be absorbed by the spreader, generate vapour and start to spread in the downstream direction through the heat spreader (3) where it will eventually condense. The length occupied by the vapour may vary between zero (no excess heat) and the full length of the system. To avoid excess vapour generation in high power events, an auxiliary optional excess vapour condenser (5) may be added to the system. This excess vapour condenser (5) is located in a place such that the vapour only reaches it once the target application (2) is fully active (full of vapour). All vapour reaching this component will be condensed so that there will be a maximum for the amount of vapour present in the system and therefore for the pressure and temperature achieved by the system under any circumstance (high thermal load events).

In an embodiment, the operating pressure range (and therefore, the operating temperature range of the target application (2)) is dependent on the total volume of the system and on the actual mass of liquid and vaporized working fluid, as well as on the non-condensable gas pressure. The pressure/temperature stability may be increased by adding extra volume to the system besides the volume of the heat spreader (3). The extra volume that may exist upstream of the excess vapour condenser (5) is called buffer volume (11), as this volume may accumulate excess vapour during high power events. The surplus vapour may be stored in this volume and will condensate, releasing its heat to the target application at a later time, when the thermal load is lower and the chambers of the heat spreader are no longer filled with vapour. The extra volume downstream of the excess vapour condenser (5) is called the expansion tank volume (6). The expansion tank volume (6) function is to increase the operating pressure and temperature stability of the system if desired. Unlike the buffer volume (11), it cannot be used for vapour accumulation, only non-condensable gas, because it is located downstream of the excess vapour condenser (5), which will condense all vapour reaching it. However, this component is important for pressure stabilization (the higher the total volume, the more stable will be the system pressure and temperature). The buffer volume (11) and expansion tank volume (6) volumes are optional and may have any shape or volume. On one hand, the thermal load peaks will be wasted if there is no buffer volume (11). On the other hand, the pressure and temperature will be less controllable if the expansion tank volume (6) is small or non-existent.

In an embodiment, the chambers contained in the heat spreader (3) may be completely separated, joined at both their ends or form one single chamber. Accordingly, the buffer volume (11) and expansion tank volume (6) may also be individual (one per individual chamber) or common to all the chambers. The excess vapour condenser (5) may be a heat exchanger of any suitable type.

In an embodiment, the optional buffer volume (11), excess vapour condenser (5) and expansion volume is a prolongation of the heat spreader (3) and typically located outside of it.

In an embodiment, the geometry of the heat spreader (3) extends the whole length of the system, unlike the hot source heat exchanger (4) which may extend to only a fraction of the system, the fraction necessary to absorb the intended heat. Fig. 4 shows the hot source heat exchanger (4) extending only to half of the thermoelectric modules (the ones at the lower body). The hot source heat exchanger (4) size should be designed according to the expected inlet thermal load, the thermal needs of the target application and the cost of the system. The heat spreader (3) and target application (1) do not need to develop along a straight line but they may fold themselves several times in zigzag for added compactness, or have a parallel stacked geometry. This way, several stacked lines of target applications (2) (e.g. thermoelectric modules) may exist as seen in Fig. 3a. Also, the target applications (2) may be aligned along the faces of a roughly prismatic geometry for compactness reasons, as depicted in Fig. 3b, c.

The second named embodiment of the disclosure is also represented by Figs 2, 3 and 4. It is similar to embodiment #1, but, the chambers of the heat spreader (3) are so densely packed or even overlapping, or the walls separating the various chamber are so thin, that the available section area for conductive heat transfer between the hot source heat exchanger (4) and the target application (2) will be very low or even non-existent. Under these conditions, most or all of the heat transfer between the heat source and the target application (2) will occur through phase change and not by conduction. This way, all the heat, not just the excess heat (as was the case embodiment #1), will be channelled and spread to the target application (2) via the heat spreader (3). Therefore, the only physical difference between embodiment #2 and embodiment #1 is that the former does not have a relevant conductive heat transfer area across the thickness of the heat spreader unlike the latter, which will rely on conduction across the spreader to transfer heat across the spreader (see Fig. 1). However, this causes them to operate in a substantially different way. While embodiment #1 will practically only use the heat spreader (3) to spread the excess heat (Fig.1), embodiment #2 will use the heat spreader (3) to spread all the heat along its active length, from the hot source to the target application.

The biggest advantage of embodiment #2 relative to embodiment #1 has to do with the protection of the target application (2) against overheating in the event of extreme thermal load or working fluid dry-out, since no relevant heat transfer will occur between the hot source heat exchanger (4) and the target application (2) in the absence of phase change. However, unlike the embodiment #1, it will operate as long as boiling conditions are present, since no relevant conductive heat transfer occurs across the heat spreader (3).

In the third named embodiment (Fig. 5), the chambers of the heat spreader (3) are partially or fully flooded with the phase change fluid so that there is no need for capillary pumping inducing features. Similarly to embodiment #1, the phase change temperature of the fluid will be that of the operating temperature limit of the target application (2) and the heat spreading in the downstream direction will only start once this temperature is achieved. As long as the thermal power is not sufficient for this to happen, the heat transfer between the hot source heat exchanger (4) and the target application (2) will occur exclusively through conduction across the heat spreader (3) body. Once the operating temperature limit of the target application (2) is achieved (which coincides with the boiling conditions for the phase change fluid), heat will be absorbed by vaporization at the hotter regions and then as this vapour is spread downstream, it will eventually condensate as it mixes with cooler fluid or as it contacts with cooler surfaces. This way a spreading of excess heat is also accomplished. A slight inclination might be required for the vapour to travel in the downstream direction. Alternatively, a vapour motion such as the one obtained in a loop heat pipe / thermosiphon may also be implemented.

A main advantage of the third embodiment relatively to the previous ones is that it does not need capillary pumping inducing features at the inner surface of the chambers. Also, the fact that there is substantial or total flooding of the chambers allows the system to operate horizontally and also tolerate higher deviations from the horizontal position when the system is operating in mobile applications.

The higher proportion of phase change fluid to non-condensable gas might require a closer attention to the design of the system (e.g. expansion volume) in order to ensure that the pressure of the chambers (and the corresponding boiling temperature) is kept within the intended bounds and the non-condensable gas is at a higher position relatively to the liquid. This means that the buffer volume (11) and expansion volumes should always be located above the heat spreader (3) chambers as depicted in Fig. 5.

Another possibility for this embodiment will be to extend in zig-zag the heat spreader (3) and target application (2) for additional stages stacked on top of the original target application (2) stage as depicted in Fig. 4. These additional stages would only receive the heat spread inside the Extension of the heat spreader (13) by the vapour inside it.

A fourth named embodiment is represented schematically in Fig. 6. The target application (2) is always located above the hot source heat exchanger (4) and the heat spreader (3), not below as in the previously referred embodiments since it works through gravity. The heat spreader (3) is similar to that of Embodiment #2, in which all of the heat transfer and heat spreading to the target application (2) is performed through phase change material. However, unlike Embodiment #2, the condensates will return by gravity, dripping from the upper surfaces where they condense down to the lower surfaces of the chambers, where the liquid is stored and vaporization takes place. Unlike Embodiment #3, the chambers are not necessarily flooded, therefore heat transfer will only occur from the lower to the upper surfaces of the chambers. For that reason, the target application (2) will need to be located upwards unless capillary pumping structures are used.

This embodiment may still incorporate meshes, wicks, hole patters or metal foams at the bottom surface of the chambers in order to promote a uniform liquid covering of the surface, avoiding dry-out.

As in the case of previous embodiments, embodiment #4 may also have an extension of the heat spreader similar to what is depicted in Fig. 4 for other embodiments.

The main advantage of this embodiment relative to the previous ones is that it does not need complex and continuous structures for capillary pumping covering all the inner surface of the chambers. Also, the lower amount of phase-change fluid needed makes the control of pressure easier than in the case of embodiment #3.

A fifth named embodiment is represented in Fig. 7. It is similar to Embodiments #1 and #2 in the sense that it also has a heat spreader (12) operating under phase change such as in the case of a gas-loaded thermosiphon. However, the hot source heat exchanger (8) is standalone, physically separated from the heat spreader (12) and the target application (2). So, the vaporization and condensation sections of the system are separated into two different bodies: the standalone hot source heat exchanger, also called evaporator (8) and the standalone heat spreader, also called condenser (12) are connected by the vapour line (9) and additionally also an optional liquid/condensate line (10). This is optional because when condensing and releasing the heat at the heat spreader (3) the liquid will either return to the evaporator (8) through a different line, called the liquid line (10) or through the same vapour line (9).

The standalone hot source heat exchanger/evaporator (8) is a heat exchanger which is able to produce vapour using the heat from the heat source and it may be a commercially available one as long as it withstands the necessary pressure. It generates vapour at the intended target temperature. This vapour rises and eventually reaches the heat spreader (3) (which in this variant may be designated as the condenser, 12) through the vapour line (9). The region to which the vapour spreads will be the active region in terms of heat transfer just as in the other cases. The pre-charge pressure of the non-condensable gas and masses and volumes of the constituents will allow determining the pressure range of variation in the design phase. The vapour condensing at the standalone heat spreader/condenser (12) will either fall back to the evaporator (8) through a dedicated line (the liquid line 10) or through the same line (the vapour line, 9) from which the vapour reaches the condenser (12) coming from the evaporator (8). A slight inclination, a capillary structure or a loop configuration similar to loop heat pipes will be necessary to ensure the return of the liquid back to the evaporator (8).

The line through which the condensates will fall back to the evaporator (8) should be located at the lowest point of the standalone heat spreader/condenser (12). It can be the liquid line (10) located at the downstream end of the system, as displayed in Fig. 7. With this configuration the system will display a loop characteristic, eliminating the typical entrainment limit of thermosiphons and heat pipes. Nevertheless, another alternative is for the condensates to fall back towards the upstream tip of the standalone heat spreader (condenser) (12) and descend back towards the evaporator (8) through a dedicated liquid line (10) or through the same line (9) from which the vapour is reaching the condenser (8). Under these conditions, the liquid will return in counter-current to the vapour having the entrainment limitation, but allowing the vapour line to be always wet, favouring a rapid vaporization.

The main advantage of this embodiment is the possibility of locating the target application (2) (such as thermoelectric generators) at a different location from the heat inlet flow (7). Only the evaporator (8) needs to be located along the heat source stream. Also, it is possible to install the condenser (12) and the target application (2) at a flexible orientation, from slightly inclined to vertical, as long as there is gravity assistance for the return of the condensates (or a capillary pumping inducing structure).

Again, this embodiment may also incorporate several stacked levels of target applications (2) similarly to what happens in Fig. 4 for other embodiments, with the heat spreader (13) extending in zig-zag along the various stacked levels.

As can be seen in all the embodiments presented, all the embodiments have in common the ability to convert the temperature of a highly variable thermal power source to a stabilized temperature range thermal source for the target application (2). This is always done through the use of a heat spreader (3) located along the heat path between the heat source (4) and the target application (2). This heat spreader (3) incorporates inner chambers containing a phase change fluid and a non-condensable gas with the same working principle as gas-loaded/variable conductance heat pipes, thermosiphons or vapour chambers.

In practical terms, the disclosure allows the absorption of heat from a variable thermal source spreading this available heat to a proportional area at the target application (2) at a controllable temperature range for the target application (2). The temperature range can be as stable as desired through a selection of the geometry of the system (namely system volume) and the phase change fluid and non-condensable gas masses and pre-charge pressure. The heat spreading is always performed through liquid-vapour phase change occurring in region located between the heat source and the target application (2).

The heat spreader (3) will spread the lower or higher incoming heat over a lower or a higher heat transfer area avoiding both thermal dilution under low loads and overheating under high loads. The variable active heat transfer area or heat spreading effect is achieved through a phenomenon which is already observed in gas-loaded heat pipes or thermosiphons, which is that heat transfer throughout the chambers occurs mainly in the regions reached by vapour.

The region reached by vapour will be proportional to the thermal load. The temperature of this vapour will be a function of local pressure which can be regulated controlled within certain limits.

While having much in common, the different embodiments all have their specificities and advantages:
The first embodiment is a compact, integrated system with heat transfer occurring by conduction from the hot source heat exchanger (4) to the target application (2) and heat spreading of the excess heat occurring along the chambers in the downstream direction. This heat spreading will only be active when the operating temperature limit is reached at the target application (2). In this event, the fluid will start boiling at the hot locations and there will be spreading of the excess heat in the downstream direction. The heat will then be released by condensation at the colder locations reached by vapour more downstream. This embodiment requires capillary pumping for the return of the condensates and is able to maximize heat absorption by the system in all situations while still being able to avoid overheating as long as the heat spreader (3) has capacity to spread the excess heat in the downstream direction.

The second embodiment is similar to the first embodiment but it has not the conductive heat transfer component across the heat spreader (3), so that all incoming heat must be transferred to the target application (2) through vaporization, spreading and condensation, and not through heat conduction across the spreader.

The heat spreading feature is done by the lower or higher rate of vapour production which originates a lower or higher fraction of the chamber occupied by vapour, which will be the area where heat transfer occurs. The big advantage of this embodiment is the ability to provide an even greater protection against overheating than the first embodiment, in the event of working fluid dry-out.

The third embodiment is similar to the first embodiment, with the heat transfer occurring through conduction across the heat spreader (3) body and with phase change occurring only when there is excess heat to be spread in the downstream direction. However, in this case the chambers are flooded by the phase change fluid along the whole length of the hot source heat exchanger (4). A slight inclination of the system will cause the vapour bubbles generated at excess heat locations to travel in the downstream direction and then condense at colder locations further downstream. It has the advantage of not needing capillary pumping inducing features and being highly tolerable to gravity direction changes.

The fourth embodiment is similar to the first and second embodiments but it relies on gravity rather than on capillary pumping for the return of the condensates. All target applications of this system have to be located above the heat spreader (3). It has the advantage of not requiring capillary-inducing structures.

The fifth embodiment is similar to the second embodiment in the sense that all heat is transferred to the target application by vapour spreading, but the vapour generation and vapour spreading and condensation are made in two different bodies linked by vapour/liquid lines. It has the advantage of allowing to locate the target application (2) in a place that is different from the heat source and allows the use of commercial evaporators.

The system of the present disclosure is suited for thermoelectric modules used as target application (2). The system may be configured so that an operating temperature close to the modules' optimum may be achieved even in highly variable thermal load applications such as in the case of heat recovery from vehicle engines. This way, all modules will always operate near their top efficiency regardless of the thermal load of the system because the heat spreader will always spread the available heat to a proportional thermoelectric module area and at a temperature range which can be close the optimal value.

The term "comprising" whenever used in this document is intended to indicate the presence of stated features, integers, steps, components, but not to preclude the presence or addition of one or more other features, integers, steps, components or groups thereof. The disclosure should not be seen in any way restricted to the embodiments described and a person with ordinary skill in the art will foresee many possibilities to modifications thereof. The above described embodiments are combinable.

## Claims

1. Heat recovery system for transferring heat from a hot-source fluid flow to a target application comprising:
a heat exchanger arranged for recovery of heat from the fluid flow, comprising an inlet and an outlet for said fluid flow,
a heat spreader between the heat exchanger and the target application, for transferring heat from the heat exchanger to the target application through said heat spreader,
wherein said heat spreader comprises one or more vapour chambers arranged along the length of the heat spreader,
wherein said vapour chambers comprise a working fluid and a non-condensable gas, wherein the working fluid is a liquid-to-vapour phase change fluid.

2. Heat recovery system according to the previous claim wherein the target application comprises one or more thermoelectric generators arranged along the length of the heat spreader and one or more heat sinks for cooling the thermoelectric generators.

3. Heat recovery system according to any of the previous claims wherein the heat sinks are arranged along the length of the thermoelectric generators, in particular the thermoelectric generators are between the heat spreader and the heat sinks.

4. Heat recovery system according to any of the previous claims wherein the vapour chambers are heat pipes or thermosiphons.

5. Heat recovery system according to any of the previous claims wherein the heat spreader comprises a metal body in which the vapour chambers are embedded.

6. Heat recovery system according to the previous claim wherein the vapour chambers are made of a first material and the metal body is made of a second material, wherein the first material has a lower conductive heat transfer resistance than the second material.

7. Heat recovery system according to any of the previous claims comprising an excess vapour condenser connected to one or more vapour chambers for condensing excess working fluid vapour.

8. Heat recovery system according to any of the previous claims wherein the liquid-to-vapour phase change material is selected from the following list: water, a heat transfer fluid which is a eutectic mixture of two stable organic compounds, or a heat transfer fluid which is a eutectic mixture of biphenyl and diphenyl oxide.

9. Heat recovery system according to any of the previous claims wherein the non-condensable gas is selected from the following list: air, nitrogen, carbon dioxide, argon, helium.

10. Heat recovery system according to any of the previous claims wherein the fluid is gaseous, in particular an exhaust gas from a combustion engine.

11. Heat recovery system according to any of the previous claims wherein the vapour chambers comprise capillaries for capillary flow of working fluid liquid towards the heat exchanger, in particular the vapour chambers comprise capillary wicks, capillary meshes, capillary metallic foams or capillary channels.

12. Heat recovery system according to any of the previous claims wherein the non-condensable gas is a gas that is non-condensable at working pressure and temperature of the system, in particular non-condensable at 20°C at the system working pressure.

13. Heat recovery system according to any of the previous claims wherein the system is arranged as a layered structure comprising, in order, the heat exchanger, the heat spreader and the target application, in particular arranged as layered structure comprising, in order, the heat exchanger, the heat spreader, the target application and the heat sink.

14. Heat recovery system according to the previous claim wherein the system comprises a plurality of said layered structures adjoined together, wherein each said layered structure is arranged in the same order as the adjoining structure or structures, or arranged in the reverse order of the adjoining structure or structures.

15. Heat recovery system according to the claim 13 wherein the system comprises a plurality of said layered structures joined as a triangular, quadrangular, rectangular, pentagonal or hexagonal prism.
